# EUROPEAN PATENT SPECIFICATION

(11) **EP 0 889 585 B1**
(45) Date of publication and mention of the grant of the patent: **29.08.2007**
(21) Application number: 98111217.0
(22) Date of filing: 18.06.1998
(51) Int. Cl.: H03H 9/10

(54) **Electric component having an electronic component device located on a face of a package member with a space therebetween**
Elektrisches Bauteil mit einem elektronischen Bauteil auf einer Seite eines Gehäuses mit einem Raum zwisschen beiden
Composant électrique comportant un composant électronique placé sur une face d'un boitier avec un espace entre eux

(30) Priority: 30.06.1997 JP 17483797
(43) Date of publication of application: 07.01.1999
(73) Proprietor: MURATA MANUFACTURING CO., LTD., Nagaokakyo-shi Kyoto-fu (JP)
(72) Inventor: Ishino, Satoshi, Nagaokakyo-shi, Kyoto-fu (JP); Kubota, Kenji, Nagaokakyo-shi, Kyoto-fu (JP); Saito, Tsuyoshi, Nagaokakyo-shi, Kyoto-fu (JP); Maesaka, Michinobu, Nagaokakyo-shi, Kyoto-fu (JP); Ogawa, Mamoru, Nagaokakyo-shi, Kyoto-fu (JP); Inoue, Jiro, Nagaokakyo-shi, Kyoto-fu (JP); Kaida, Hiroaki, Nagaokakyo-shi, Kyoto-fu (JP)
(74) Representative: Laufhütte, Dieter

(56) References cited:
- EP-A- 0 241 236
- EP-A- 0 637 871
- EP-A- 0 665 644
- EP-A- 0 735 671
- PATENT ABSTRACTS OF JAPAN vol. 017, no. 418 (E-1408), 4 August 1993 (1993-08-04) & JP 05 083074 A (MURATA MFG CO LTD), 2 April 1993 (1993-04-02)

## Description

The present invention relates to a method of forming an electronic component, such as a piezoelectric resonance device, having an electronic component device located on a face of a package member with a space therebetween, and an electronic component formed by this method.

Among electronic component devices, there are some devices which require that part thereof will not contact with a printed circuit substrate when mounted on the printed circuit substrate or the like. For instance, as for a piezoelectric resonator, a resonating section thereof must be disposed by leaving a certain space from the printed circuit substrate in order not to interfere the oscillation of the resonating section. In case of an exothermic electronic component device, it is necessary to mount the electronic component device while leaving a certain space between the printed circuit substrate in order to suppress heat from conducting to the printed circuit substrate and others.

Various structures have been proposed for a piezoelectric resonator in order to create such a space.

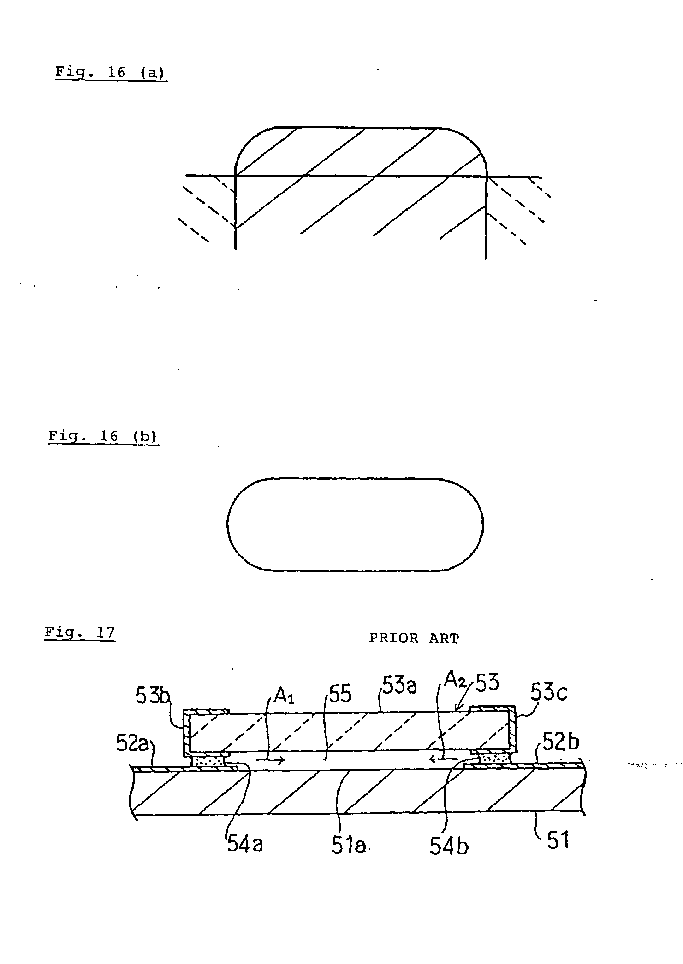

FIG. 17 is a partially cutaway section view showing one example of a prior art structure for mounting a piezoelectric resonator.

Electrode lands 52a and 52b are formed on a substrate 51. A piezoelectric resonator 53 is mounted against the electrode lands 52a and 52b. The piezoelectric resonator 53 has a structure in which a terminal electrode 53b is formed at one end of a piezoelectric plate 53a and a terminal electrode 53c is formed at the other end. It is noted that a resonance electrode not shown is connected to the terminal electrodes 53b and 53c.

The terminal electrodes 53b and 53c are joined to the electrode lands 52a and 52b via conductive adhesives 54a and 54b applied so as to have a certain thickness in order not to interfere the oscillation of a resonating section.

That is, a gap 55 is created between the piezoelectric resonator 53 and an upper face 51a of the substrate 51 by thickening the conductive adhesives 54a and 54b.

However, because the conductive adhesives 54a and 54b are liquid when it is applied, it is liable to flow in the direction of the center of the piezoelectric resonator 53 as shown by arrows A₁ and A₂ in FIG. 17. As a result, there has been a case when the resonating section is joined to the upper face 51a of the substrate 51 by the conductive adhesive in the mounting structure thus obtained, degrading resonating characteristics.

Further, because the liquid conductive adhesives 54a and 54b are hardened after the application, the thickness of the space 55 varies and there has been a case when the resonating section contacts with the upper face 51a of the substrate 51, damaging the resonating characteristics.

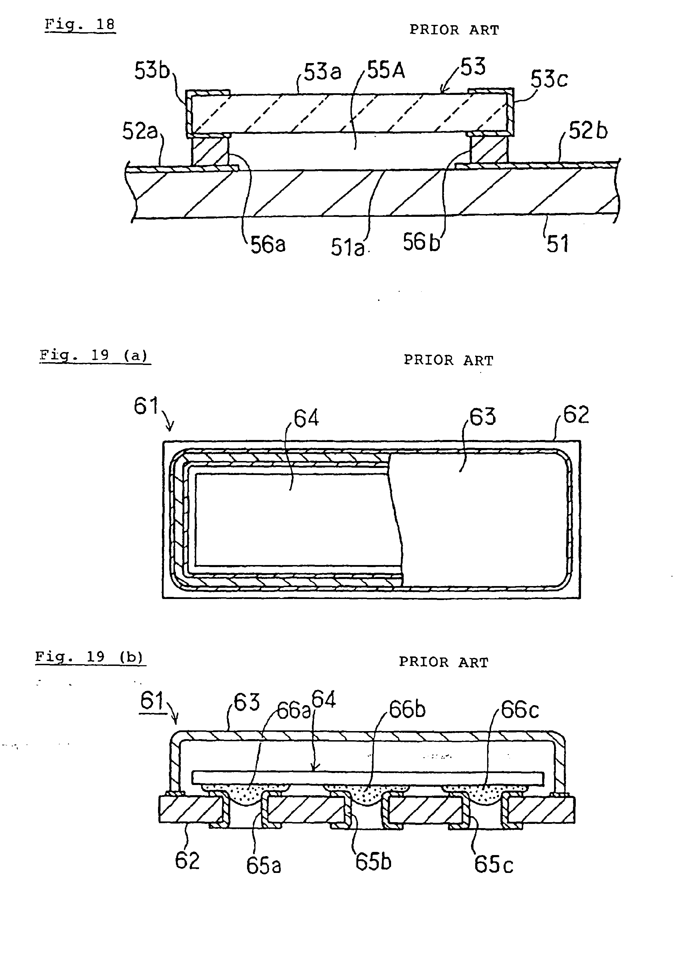

In order to eliminate the aforementioned problems, there has been proposed a mounting structure in which spacers 56a and 56b are interposed between the terminal electrodes 53b and 53c and the electrode lands 52a and 52b as shown in FIG. 18. The spacers 56a and 56b are made of an electrically conductive material such as metal and are joined to the terminal electrodes 53b and 53c as well as the electrode lands 52a and 52b by using conductive adhesive or solder. Here, a space 55A having an enough height is assured between the piezoelectric resonator 53 and the upper face 51 a of the substrate 51 by the height of the spacers 56a and 56b.

However, it requires to prepare the spacers 56a and 56b and to carry out cumbersome works of applying the spacers 56a and 56b to join the piezoelectric resonator 53.

Meanwhile, there has been disclosed a small package structure for storing a piezoelectric resonator and the like in Japanese Patent Laid-Open No. Hei. 5-83074. Figs. 19a and 19b are partially cutaway plan view and a section view showing the package structure described in this prior art technology.

The electronic component 61 is constructed by an insulating substrate 62 and a cap 63. A piezoelectric resonator 64 is stored within the package. Further, through hole electrodes 65a through 65c are formed through the substrate 62. The through hole electrodes 65a through 65c are constructed by creating through holes through the substrate 62 and by applying an electrode material on the inner peripheral faces of the through holes. At this time, not only the inner peripheral faces of the through holes, the electrodes extend also to the upper and lower faces so as to form flange-like portions.

The piezoelectric resonator 64 is joined to the through hole electrodes 65a through 65c via conductive adhesives 66a through 66c. Not only entering the through hole electrodes 65a through 65c, the conductive adhesives 66a through 66c are joined also to the flange like portion at the upper face of the substrate 62 of the through hole electrodes 65a through 65c.

It is said that the electronic component 61 allows an area outside of the cap 63 to be reduced and thereby the device to be miniaturized because the piezoelectric resonator 64 is led to the outside by using the through hole electrodes 65a through 65c.

However, because the piezoelectric resonator 64 is joined to the through hole electrodes 65a through 65c by using the conductive adhesives 66a through 66c also in the electronic component 61, there has been a case when oscillation of the resonating section is damaged by the conductive adhesives 66a through 66c which flow and extend during its application similarly to the case of the mounting structure 51 shown in FIG. 17.

As described above, there has been a fear of degrading the resonance characteristics by the mounting structure 51 shown in FIG. 17 and by the electronic component 61 shown in FIG. 19 because the space of predetermined thickness cannot be assured due to the fluidity and extendibility of the conductive adhesive.

Further, the mounting structure shown in FIG. 18 has had problems that although it allows the space 55A having an enough thickness to be created, its fabrication process is complicated and it is costly because the spacers 56a and 56b have to be used.

From EP-A-0 665 644 an electronic component is known comprising: a package member; a plurality of through holes provided in a package member; at least one via hole electrode provided in at least one of the plurality of through holes and extends through the at least one through hole in the substrate so as to protrude by a protruding amount from a first face of said package member; an electronic component device located on the first face of said package member with a space therebetween; the space between the electronic component device and the first face of said package member being determined by the protruding amount of the via hole electrode protruding from the face of said package member, the at least one via hole electrode having a protruding portion which does not extend along the face of said package member during a manufacturing step. However, the via holes are created in an already sintered substrate and preformed via hole electrodes are inserted into these via holes, making the control of the protruding portions difficult.

It is the object of the present invention to provide a method of forming an electronic component which allows an electronic component device to be fixed firmly to a package member with a space therebetween and can be readily fabricated and to provide an electronic component formed by this method.

This object is achieved with a method of forming an electronic component according to claim 1 and an electronic component according to claim 3. Preferable embodiments form the subject matter of subclaims.

The present invention provides a method of forming an electronic component, comprising the steps of: laminating a plurality of ceramic green sheets on a support film to obtain a ceramic green sheet laminate; forming through holes through the ceramic green sheet laminate at positions where via hole electrodes are to be located; applying conductive material into the through holes so as to fill the through holes and so as to be located on the upper surface of the ceramic green sheet laminate to form via hole electrodes; and sintering the ceramic green sheet laminate to form a substrate and so as to form protruding portions of the via hole electrodes which protrude upward from the upper surface of the substrate.

The above described method may further comprise the step of cooling the ceramic green sheet laminate, wherein a coefficient of thermal contraction of the ceramic green sheet material is higher than a coefficient of thermal contraction of the conductive electrode material.

The via hole electrodes that are formed by the above process are solid and substantially rod-shaped. The via hole electrodes formed by the above process fill the via holes with the solid, rod-shaped configuration. The protruding portions are formed because a coefficient of thermal contraction of the ceramics, during cooling after the sintering, is higher as compared to a coefficient of thermal contraction of the electrode material.

As a result of the protruding portions of the via hole electrodes, a gap having a sufficient size or vertical dimension can be reliably created below the piezoelectric resonator and the substrate.

The present invention further provides an electronic component formed by the above described method, comprising: a package member; a plurality of through holes provided in a package member; at least one via hole electrode provided in at least one of the plurality of through holes and extends through the at least one through hole in the substrate so as to protrude by a protruding amount from a first face of said package member; an electronic component device located on the first face of said package member with a space therebetween; the space between the electronic component device and the first face of said package member being determined by the protruding amount of the via hole electrode protruding from the face of said package member; and a joining member joining the electronic component device with the via hole electrode.

It is noted that the via hole electrode described in the present specification means a solid electrode in which an electrode material is filled completely within a through hole as described later.

In addition, the at least one via hole electrode may have a protruding portion which does not extend along the face of said package member.

By the above described structure, the space having a desired thickness can be assured between the electronic component device and the package member. Accordingly, it becomes possible to provide the electronic component suitable for the electronic component device such as a piezoelectric resonator which is required to be mounted on the package member by leaving a space so that oscillation of its resonating section is not interfered.

In addition, although there has been a case when the desired space cannot be obtained due to the fluidity and extendibility of the adhesive during its application in the prior art in which the space between the electronic component device and the package member is created by the conductive adhesive, the space of the desired thickness can be assured by the present invention because the protruding portions of the via hole electrodes are utilized. Further, because the present invention requires no extra member such as a spacer to create the space having the desired thickness, there is no fear of increasing the cost of the electronic component.

In the above described electronic component, the electronic component device may be a piezoelectric resonator.

By the above structure, the electronic component having excellent resonance characteristics can be obtained.

In the above described electronic component, the via hole electrode may be exposed to a second face of the package member; and the first and the second face of the package member are opposed to each other.

By the above described structure, the electronic component device at the upper face (the first face) of the package member may be electrically connected with the lower face (the second face) of the package member by using the via hole electrodes. Accordingly, it allows the electronic component which can be readily mounted on the surface to be obtained by forming connecting and terminal electrodes on the lower face of the package member.

In the above described electronic component, the package member may comprise ceramic, a plurality of internal electrodes may be provided in the package member so as to form at least one capacitor, and the via hole electrode may be electrically connected to the capacitor.

By the above described structure, it can be obtained that an electronic component including a complex type package structure having a circuit in which the capacitors are connected to the electronic component device mounted on the package member.

In the above described electronic component, the package member may comprise a ceramic substrate, a plurality of cutaways may be provided on a side of the ceramic substrate, and a plurality of external electrodes may be provided in the plurality of cutaways respectively.

By the above described structure, it becomes possible to form the external electrodes readily by using the same method with that for forming the via hole electrodes and to provide the smaller electronic component as compared to the external electrode using through hole electrodes.

### BRIEF DESCRIPTION OF THE DRAWINGS

FIG. 1 is a longitudinal section view showing an electronic component according to a first embodiment of the present invention.
FIG. 2 is a transverse section view of the electronic component shown in FIG. 1 along a line A-A in FIG. 1.
FIG. 3 is a transverse section view for explaining an electronic component according to a second embodiment of the present invention.
FIG. 4 is a plan view of the electronic component device shown in FIG. 3.
FIG. 5a is a partially cutaway section view for explaining a through hole electrode.
FIG. 5b is a partially cutaway section view for explaining a via hole electrode.
FIG. 6a and 6b are schematic plan views for explaining a positional relationship between an external electrode and an electronic component device formed by the same method with the through hole electrode and the via hole electrode, respectively..
FIG. 7 is a transverse section view for explaining a modified example of the first embodiment.
FIGs. 8a is a longitudinal section view for explaining another modified example of the first embodiment.
FIGs. 8b is a transverse section view for explaining another modified example of the first embodiment.
FIGs. 9a is a longitudinal section view for explaining a still other modified example of the first embodiment.
FIGs. 9b is a transverse section view for explaining a still other modified example of the first embodiment.
FIG. 10 is a transverse section view for explaining a modified example shown in FIG. 9b.
FIG. 11 is an exploded perspective view for explaining an electronic component according a third embodiment of the present invention.
FIG. 12 is a perspective view showing an appearance of the electronic component of the third embodiment.
FIG. 13 is a longitudinal section view of the third embodiment.
FIG. 14 is a section view along a line D-D in FIG. 13.
FIG. 15 is a section view corresponding to a part along a line E-E in FIG. 13.
FIGs. 16a is a section view for explaining a via hole electrode whose plan shape is elliptic.
FIGs. 16b is a section and plan view for explaining a via hole electrode whose plan shape is elliptic.
FIG. 17 is a section view for explaining a prior art electronic component.
FIG. 18 is a partially cutaway section view for explaining another example of a prior art electronic component.
FIGs. 19a is a partially cutaway plan view for explaining a still other example of a prior art electronic component.
FIGs. 19b is a partially cutaway section view for explaining a still other example of a prior art electronic component.

Other features and advantages of the present invention will become apparent from the following description of the invention which refers to the accompanying drawings.

### PREFERRED EMBODIMENT OF THE PRESENT INVENTION

### (First Embodiment)

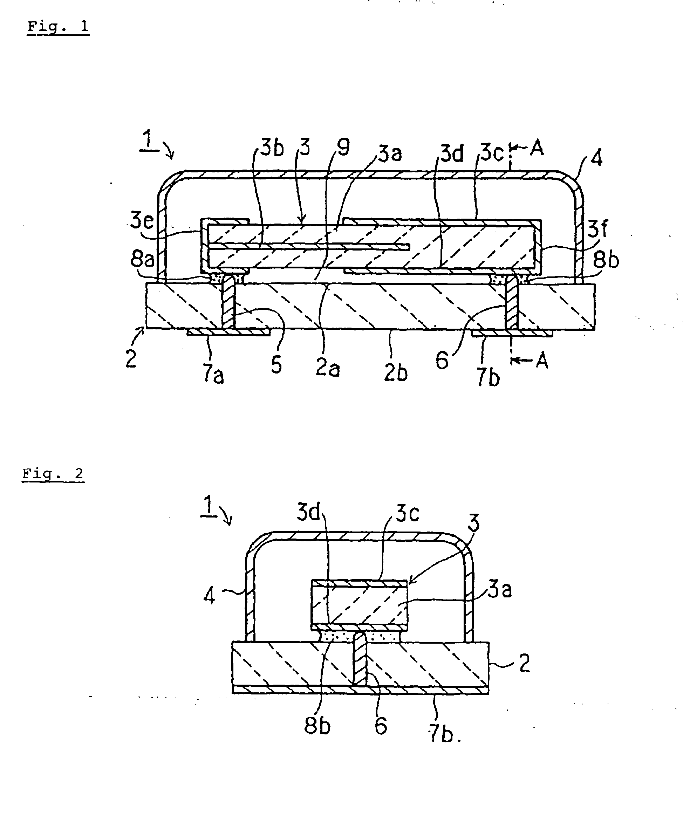

FIGs. 1 and 2 are frontal and side section views showing an electronic component according to a first embodiment of the present invention.

In the electronic component 1 shown in FIG. 1, a piezoelectric resonator 3 is mounted as an electronic component device on a substrate 2 as a package member. Further, a cap 4 made of a metal is fixed so as to surround the piezoelectric resonator 3. That is, the cap 4 creates an internal space for storing the piezoelectric resonator 3 by having a shape opened downward and by being fixed to the upper face of the substrate 2 by adhesive (not shown).

The substrate 2 is made of insulating ceramics such as alumina. Via hole electrodes 5 and 6 are created through the substrate 2. The via hole electrodes 5 and 6 penetrate through the substrate 2 and their upper ends protrude upward from the upper face 2a of the substrate 2. Lower faces of the via hole electrodes 5 and 6 are exposed to a lower face 2b of the substrate 2 and are connected to terminal electrodes 7a and 7b formed on the lower face 2b of the substrate 2.

The piezoelectric resonator 3 is constructed by using a piezoelectric member 3a formed of piezoelectric ceramics such as titanate piezoelectric ceramics. The piezoelectric member 3a is polarized in the thickness direction and has an internal electrode 3b inside. Further, electrodes 3c and 3d are formed at the upper and lower faces of the piezoelectric member 3a so that they overlap with the internal electrode 3b at the middle region of the piezoelectric member 3a. The internal electrode 3b is formed at one end of the piezoelectric resonator 3 and is electrically connected to a terminal electrode 3e which extends to the bottom face of the piezoelectric member 3a. Meanwhile, the electrodes 3c and 3d are electrically connected each other by a terminal electrode 3f formed at the other end of the piezoelectric member 3a.

The piezoelectric resonator 3 is an energy confinement type piezoelectric resonator utilizing a thickness longitudinal oscillation mode and is driven when AC voltage is applied between the terminal electrodes 3e and 3f. The piezoelectric resonator 3 is placed on the part of the via hole electrodes 5 and 6 protruding from the upper face 2a of the substrate 2 and is fixed thereto by conductive adhesives 8a and 8b on the substrate 2.

Because the upper ends of the via hole electrodes 5 and 6 protrude upward from the upper face 2a of the substrate 2 as described above, a space 9 having an enough thickness which will not interfere resonance of a resonating section is assured between the lower face of the piezoelectric resonator 3 and the upper face 2a of the substrate 2. That is, the present embodiment is characterized in that the via hole electrodes 5 and 6 are provided through the substrate 2, the upper ends of the via hole electrodes 5 and 6 protrude upward from the upper face 2a and the piezoelectric resonator 3 is disposed while leaving the space having the thickness corresponding to the protrusion of the via hole electrodes 5 and 6.

Here, the via hole electrodes 5 and 6 are constructed by filling an electrode material in the through holes created through the substrate 2. The upper protrusion of the via hole electrodes 5 and 6 is created by the following fabrication method.

That is, before obtaining the substrate 2, a plurality of ceramic green sheets are laminated on a support film to obtain a ceramic green sheet laminate. Next, through holes are created through the ceramic green sheet laminate at the portions where the via hole electrodes 5 and 6 are to be formed. Next, squeegee is performed from above the ceramic green sheet laminate supported by the support film to fill liquid or slurry conductive member such as conductive paste to the through holes. Because the conductive member is filled in the through holes by means of squeegee, the upper face of the electrode member filled in the through holes is shared with the upper face of the ceramic green sheet laminate.

However, when the ceramic green sheet laminate described above is sintered to obtain the substrate 2, the protrusion portions which protrude upward from the upper face 2a of the substrate 2 are created above the via hole electrodes 5 and 6 as shown in FIG. 1 because a coefficient of thermal contraction of the ceramics in cooling it after the sintering is higher as compared to a coefficient of thermal contraction of the electrode material, i.e. the coefficient of thermal contraction of the electrode material is smaller.

According experiments carried out by the inventor of this application, it has been confirmed that the space 9 having the enough thickness can be reliably created below the piezoelectric resonator 3 by setting the coefficient of thermal contraction of the ceramics to be higher than the coefficient of thermal contraction of the electrode material filled in the through holes by 1 to 20 % in cooling it after the sintering. It is noted that when the difference of coefficient of thermal contractions described above is less than 1 %, there is a case when the height of the protrusion portion of the via hole electrodes 5 and 6 becomes insufficient and the space 9 having an enough thickness cannot be created. When it exceeds 20 %, there is a case when the protrusion portion of the via hole electrodes 5 and 6 becomes too high, thus unstabilizing the piezoelectric resonator 3, making it difficult to stably perform joining works by the conductive adhesives 8a and 8b or giving bad influence on the characteristics. It also makes it difficult to lower the height of the electronic component 1.

### (Second Embodiment)

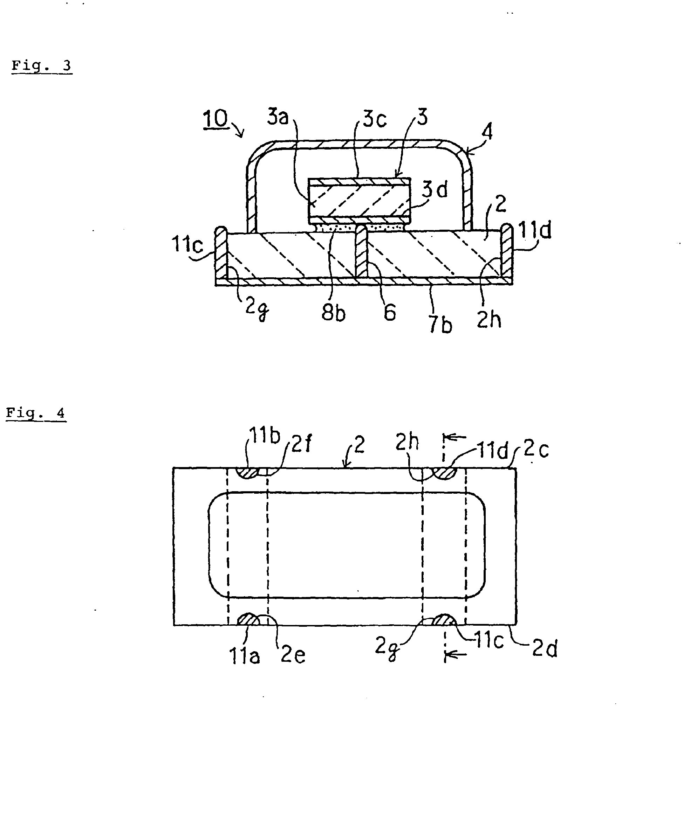

FIGs. 3 and 4 are section and plan views for explaining a second embodiment of the present invention.

FIG. 3 corresponds to FIG. 2 shown for the first embodiment.

A electronic component 10 of the second embodiment is characterized in that electronic components 11a,11b, 11c and 11d which are formed by the same method with the via hole electrodes 5 and 6 are formed on the sides of the substrate 2. The other points are the same with the electronic component 1 of the first embodiment.

That is, the electronic components 11a, 11b, 11c and 11d are formed by completely filling the electrode material within semi-circular, when seen in plan, cutaways 2e through 2h formed on side faces 2c and 2d of the substrate 2. That is, the electrode material composing the external electrodes 11a through 11d is applied so as to almost fill the cutaways 2e through 2h and so as not to reach the upper and lower faces of the substrate 2.

The external electrodes 11a through 11d are formed in the same manner with the via hole electrodes 5 and 6. That is, a mother substrate for obtaining a plurality of substrates 2 are prepared, circular through holes whose plan shape is twice of that of the cutaways 2a through 2h are created at the positions corresponding to the cutaways 2e through 2h on the mother substrate and in the same time, through holes for forming the via hole electrodes 5 and 6 are created.

After that, a liquid conductive member such as a conductive paste is filled in each through hole by means of squeegee and the mother ceramic green sheet laminate is cut in unit of each substrate. Thus, the ceramic green sheet laminate in which the electrode material is filled in the cutaways 2e through 2h is obtained. When the ceramic green sheet laminate is sintered and then cooled, the electrode material filled in the cutaways 2a through 2h are baked and the external electrodes 11 a through 11d are formed as the substrate 2 is sintered and the via hole electrodes 5 and 6 are baked.

Accordingly, the external electrodes 11a through 11d are formed through the same process with the via hole electrodes 5 and 6. Still more, the electronic components 11c and 11d are formed so as to be electrically connected with a terminal electrode 7b formed at the lower face of the substrate 2. Accordingly, in surface-mounting it on a printed circuit substrate or the like, this the electronic component 10 may be joined to electrode lands of the printed circuit substrate or the like by utilizing the external electrodes 11a through 11d by means of soldering or the like. At this time, while a soldering fillet is formed in joining the external electrodes 11a through 11d formed at the sides with the electrode lands, the state of join between the external electrodes 11a through 11d and the electrode lands may be readily confirmed visually from the outside.

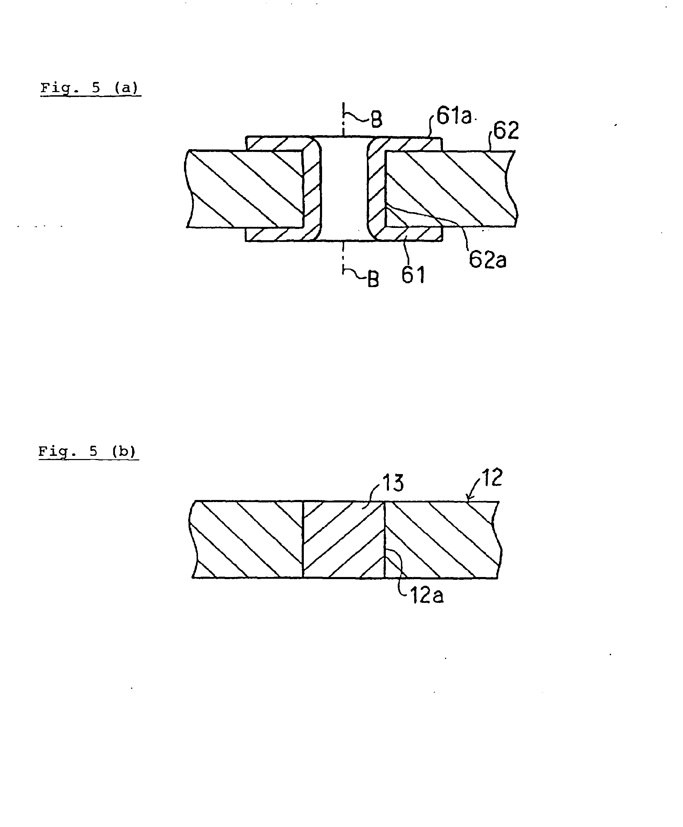

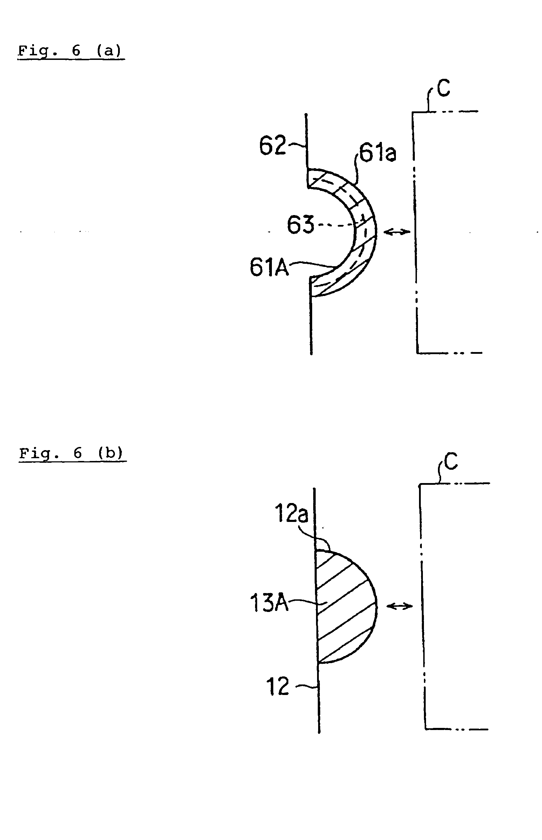

The electronic component 10 of the present embodiment allows not only the state of connection when mounted on the printed circuit substrate or the like to be readily confirmed visually but also the size of the substrate to be reduced as compared to the prior art electronic component in which external electrodes are formed on the side of the substrate in the same manner with through hole electrodes (FIG. 19) by forming the external electrodes 11a through 11d as described above. This will be explained with reference to FIGs. 5 and 6.

FIG. 5a is a partially cutaway section view showing a prior art known through hole electrode. The through hole electrode 61 is formed by creating a through hole 62a through a substrate 62 and by applying an electrode material so as to reach to an inner peripheral and to upper and lower faces of the through hole 62.

However, the via hole electrode is formed by creating a through hole 12a through a mother substrate 12 and by filling an electrode material 13 within the through hole 12a as shown in FIG. 5b.

Accordingly, when the through hole electrode 61 is formed and is cut at an alternate dotted line B in FIG. 5a to form a semi-circular, when seen in plan, external electrode in the stage of the mother ceramic laminate, a flange portion 61 a of the through hole electrode 61 is formed so as to extend to the inside more than a cutaway 63 at the upper and lower faces of the substrate 62 as shown in FIG. 6a.

When the external electrode 13A is formed as shown in FIG. 6b by cutting along the center of the via hole electrode 13 on the other hand, the external electrode 13A will not extend to the inside more than the cutaway 12a. Accordingly, when a distance between an inner edge of the external electrode 61A shown in FIG. 6a and an electronic component device C mounted on the substrate 62 is equalized with a distance between an inner edge of the external electrode 13A in FIG. 6b and the electronic component device C mounted on the substrate 12, the size of the substrate 12 which does not have the flange portion 61a may be reduced as compared to the substrate 62 by that portion. That is, the use of the external electrode 13A formed in the same manner with the via hole electrode allows the substrate to be miniaturized as compared to the external electrode 61A formed in the same manner with the through hole electrode.

Accordingly, although the external electrodes 11a through 11d are formed in the electronic component 10 shown in FIGs. 3 and 4, it allows the substrate 2 to be miniaturized or the the electronic component 10 to be miniaturized as compared to the case of using the prior art external electrode formed in the same manner with the through hole electrode.

### (Modified Example)

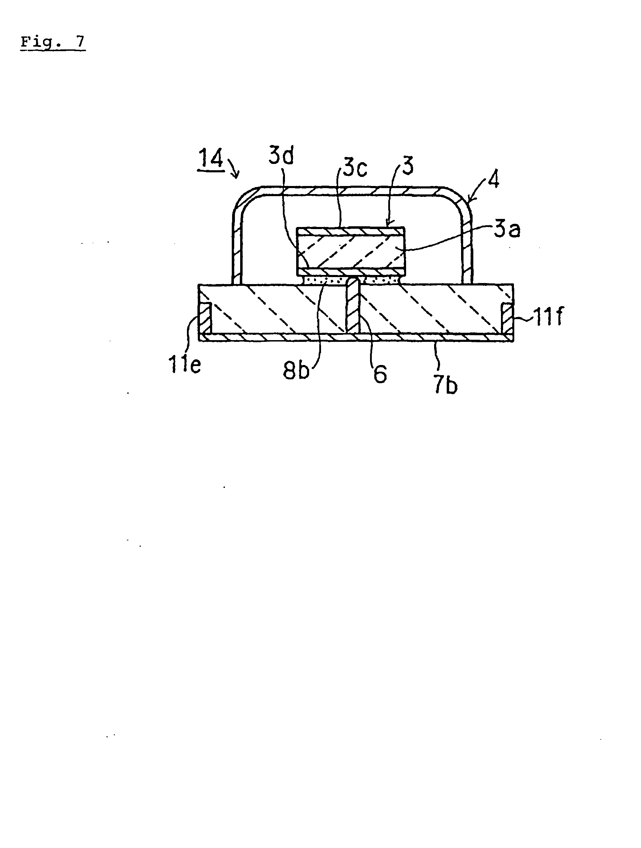

Although the external electrodes 11c and 11d which are formed on the side of the substrate 2 have been formed so as to protrude upward from the upper face of the substrate 2 in the electronic component 10 shown in FIG. 3, external electrodes 11e and 11f which extend to the intermediate height position may be formed as shown in FIG. 7 instead of the external electrodes 11c and 11d. The state of the electrode lands on the printed circuit substrate joined with the external electrodes 11e and 11f by means of soldering may be readily confirmed visually when a the electronic component 14 is mounted on the printed circuit substrate or the like also when the external electrodes 11e and 11f are formed. Further, the substrate 2 may be miniaturized in the same manner with the second embodiment.

The external electrodes 11e and 11f may be formed as follows. A number of ceramic green sheets which corresponds to a ceramic layer on which the external electrodes 11e and 11f are to be formed are laminated on a support film in obtaining a ceramic green sheet laminate by laminating the ceramic green sheets. At his time, through holes are created through each ceramic green sheet at the part where the external electrodes 11e and 11f are to be formed and a conductive member is injected to each through hole in advance. Then, the plurality of ceramic substrates are laminated while aligning the corresponding through holes to which the conductive member has been injected. Next, a second number of ceramic green sheets corresponding to the ceramic layer which is located above the upper end of the external electrodes 11e and 11f are laminated. Through holes are created through the second ceramic green sheets at the position where the via hole electrodes 5 and 6 are to be formed and a conductive member is filled in the through holes in advance of the lamination also in this case.

Then, the substrate 2 on which the external electrodes 11e and 11f are formed may be obtained by cutting the mother ceramic green sheet laminate in unit of each individual substrate and by sintering it.

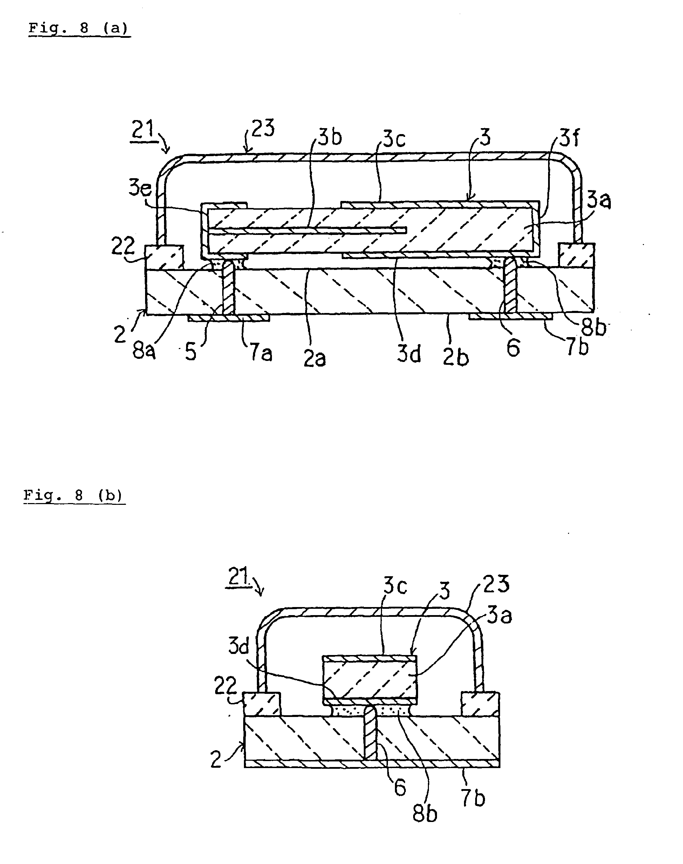

FIGs. 8a and 8b are longitudinal and transverse section views showing another modified example of the electronic component 1 of the first embodiment.

Although the cap 4 has been fixed on the substrate 2 in the electronic component 1, the structure of the package for storing the electronic component device may be changed as necessary in the present invention.

That is, a structure in which a rectangular frame-like frame 22 is combined with a cap 23 may be adopted like a electronic component 21 shown in FIGs. 8a and 8b instead of the cap 4. Here, the rectangular frame-like frame 22 made of insulating ceramics such as alumina is fixed to the upper face of the ceramic substrate by using insulating adhesive and the cap 23 made of metal or plastic is fixed on the frame 22. The other components are the same with those of the electronic component 1 shown in FIG. 1, so that the same parts are denoted by the same reference numerals and explanation thereof will be omitted here.

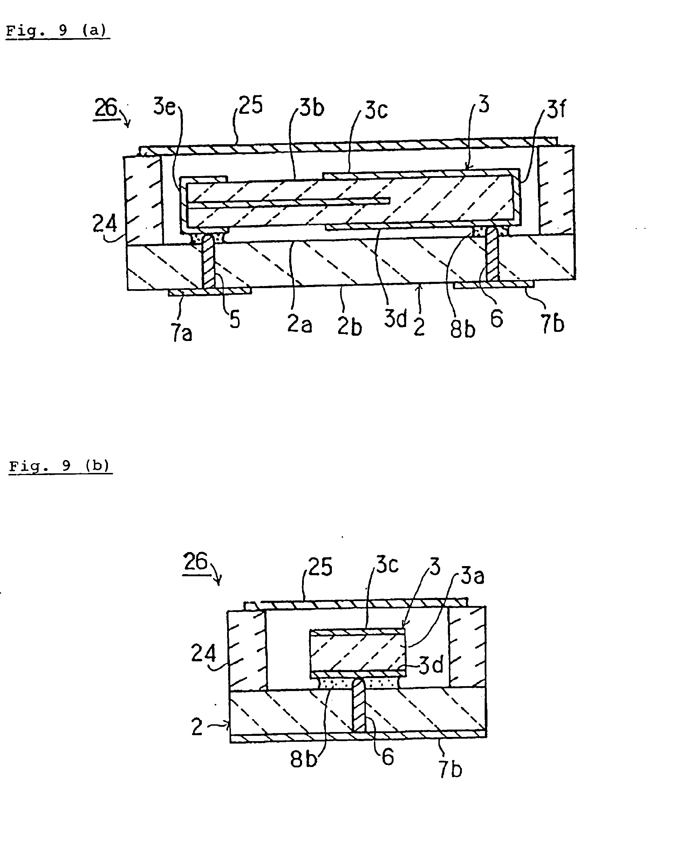

It is also possible to construct a package by using a frame 24 which is thikker than the piezoelectric resonator 3 and by fixing a plate-like lid 25 on the upper face of the frame 24 as shown in Figs. 9a and 9b. An electronic component 26 shown in FIGs. 9a and 9b is constructed in the same manner with the electronic component 1 except of that the frame 24 and the plate-like lid 25 are used instead of the cap 4 (FIG. 1)

It is noted that the material composing the frame 24 and the cap 25 is not specifically limited. Further, the frame may be made of the same material with the substrate or may be sintered in the same time with the substrate.

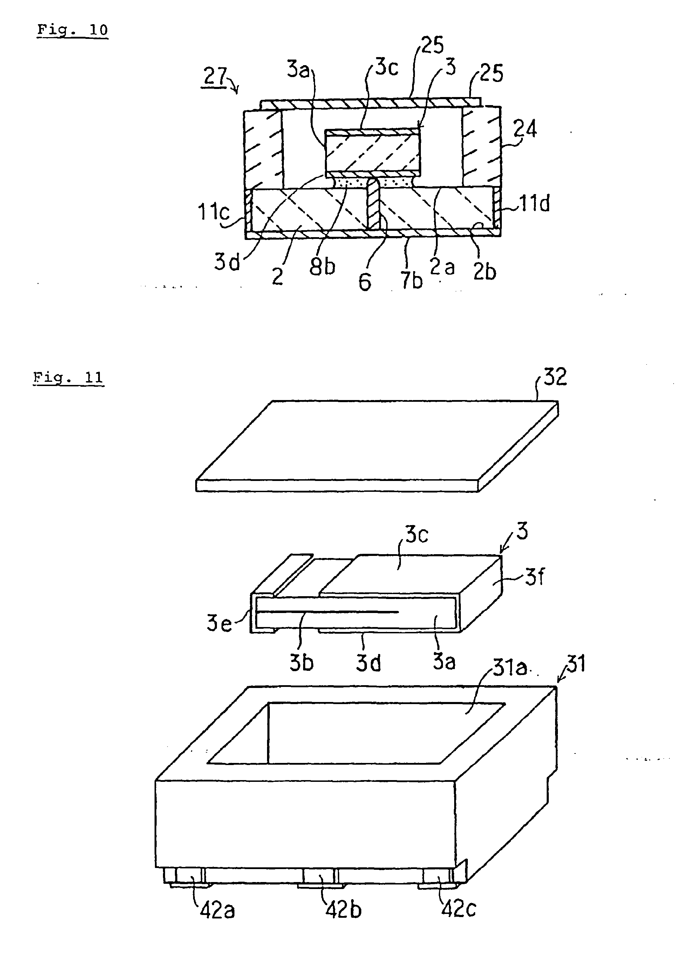

It is also possible to construct so as to be able to confirm fillet caused by solder or the like visually from the outside when mounted on a printed circuit substrate or the like by forming external electrodes 11c and 11d on the side of the ceramic substrate 2 like an electronic component 27 shown in a transverse section view of FIG. 10 in the same manner with the electronic component 10 shown in FIG. 3.

### (Third Embodiment)

An electronic component according to a third embodiment of the present invention will be explained with reference to FIGs. 11 through 15.

In the present embodiment, the package is composed of a bottomed square cylindrical package member 31 having an opening 31a at the upper part thereof and a plate-like lid 32 fixed so as to close the opening 31 as shown in an exploded perspective view of FIG. 11. A piezoelectric resonator 3 as an electronic component device is stored within the package. The piezoelectric resonator 3 is constructed in the same manner with the piezoelectric resonator 3 shown in FIG. 1.

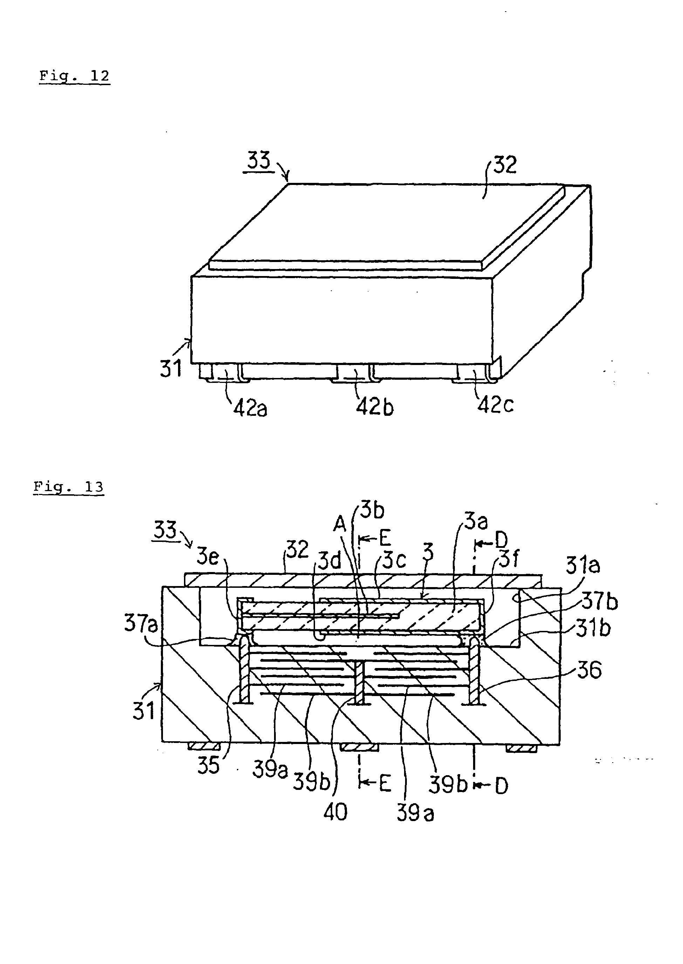

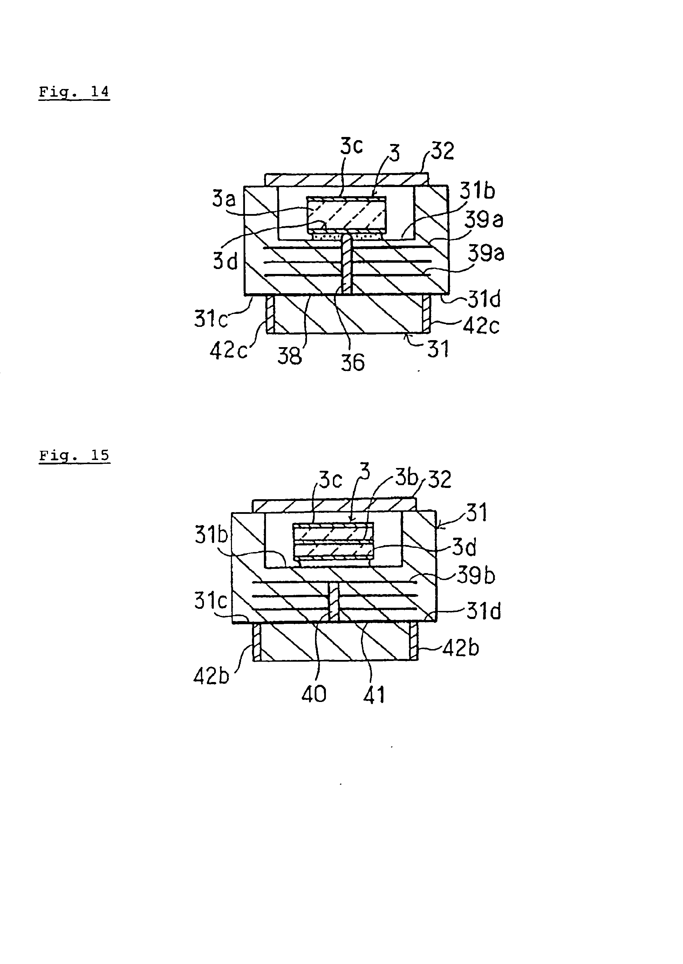

Accordingly, the electronic component 33 obtained in the present embodiment has almost a rectangular parallelepiped shape as a whole as shown in FIG. 12. FIG. 13 shows a longitudinal section view of the the electronic component 33, FIG. 14 shows a transverse section view along an alternate dotted line D-D in FIG. 13 and FIG. 15 shows a section corresponding to a part along an alternate dotted line E-E in FIG. 13.

The package member 31 is made of dielectric ceramics such as alumina. Via hole electrodes 35, 36 and 40 are formed through the package member 31 so as to penetrate through the ceramic layer. The via hole electrodes 35 and 36 protrude upward from an inner bottom 31b of the package member 31. Accordingly, the piezoelectric resonator 3 placed on the package member 31 is disposed so as to float from the inner bottom 31b while leaving a space A having a predetermined thickness. Further, the piezoelectric resonator 3 is connected with the via hole electrodes 35 and 36 by conductive adhesives 37a and 37b.

Meanwhile, the package member 31 has steps 31c and 31d at one pair of sides facing to each other. As shown in FIG. 14, the via hole electrode 36 is extended to the position of height where the steps 31c and 31d are created. A lower edge of the via hole electrode 36 is electrically connected with a connecting electrode 38 which is formed at the position of height where the steps 31c and 31d are created.

A plurality of internal electrodes for composing capacitors are formed between the inner bottom 31b of the package member 31 and the step 31d. That is, a plurality of internal electrodes 39a connected to the via hole electrodes 35 and 36 and a plurality of internal electrodes 39b connected to the via hole electrode 40 are formed. The internal electrodes 39a and the internal electrodes 39b are disposed so as to overlap each other via the ceramic layers.

The via hole electrode 40 is connected to the upper most internal electrode among the internal electrodes 39b and the upper edge thereof does not reach the inner bottom 31b as it is apparent from FIG. 13. Meanwhile, the lower edge of the via hole electrode 40 extends to the position of height where the steps 31c and 31d are formed and is electrically connected with a connecting electrode 41.

External electrodes 42a through 42c are formed at the part below the steps 31c and 31d of the package member 31 on the sides thereof (see FIG. 11). The external electrodes 42 through 42c are formed on the pair of sides facing to each other.

As shown in FIG. 14, the external electrodes 42c and 42c are electrically connected with a connecting electrode 38 and is electrically connected with the via hole electrode 36 accordingly. Meanwhile, the external electrodes 42b and 42b are connected with the connecting electrode 41 and is electrically connected with a via hole electrode 41 accordingly as shown in FIG. 15.

Therefore, a circuit structure in which the piezoelectric resonator and two capacitors are connected between the external electrodes 42a through 42c may be realized in the the electronic component 33 of the present embodiment.

As described above, the electronic component of the present invention permits the capacitors formed of the plurality of internal electrodes to be constructed within the package member. In this case, a desired circuit may be structured by electrically connecting the plurality of internal electrodes with the via hole electrodes.

Because the electronic component 33 of the present embodiment has the circuit structure in which the piezoelectric resonator and two capacitors are connected as described above, it may be suitably used as a piezoelectric resonator for example.

### (Modified Example of Planar Via Hole Electrode)

Although the via hole electrode having a circular transverse section has been shown in the above-mentioned embodiments, the sectional profile of the via hole electrode is not limited to be circular in the present invention. For instance, the section of a via hole electrode 42 may be elliptic as shown in FIGs. 16a and 16b. In such a case, an electronic component device may be stably placed by part 42a protruding from a package member 43. The sectional profile of the via hole electrode is not limited to the ellipse and may assume any shape such as.a rectangular or square shape.

Further, it is possible to support an electronic component device more stably by disposing a plurality of via hole electrodes in close proximity.

## Claims

1. A method of forming an electronic component, comprising the steps of:
laminating a plurality of ceramic green sheets on a support film to obtain a ceramic green sheet laminate;
forming through holes through the ceramic green sheet laminate at positions where via hole electrodes are to be located;
applying conductive material into the through holes so as to fill the through holes and so as to be located on the upper surface of the ceramic green sheet laminate to form via hole electrodes; and
sintering the ceramic green sheet laminate to form a substrate and so as to form protruding portions of the via hole electrodes which protrude upward from the upper surface of the substrate.

2. The method according to claim 1, further comprising the step of cooling the ceramic green sheet laminate, wherein a coefficient of thermal contraction of the ceramic green sheet material is higher than a coefficient of thermal contraction of the conductive electrode material.

3. An electronic component formed by the method according to claim 1, comprising:
a package member (2);
a plurality of through holes provided in a package member (2);
at least one via hole electrode (5, 6) provided in at least one of the plurality of through holes and extending through the at least one through hole in the substrate (2) so as to protrude by a protruding amount from a first face (2a) of said package member (2); and
an electronic component device (3) located on the first face (2a) of said package member with a space (9) therebetween;
the space between the electronic component device (3) and the first face of said package member (2) being determined by the protruding amount of the via hole electrode(5, 6) protruding from the face (2a) of said package member (2);
a joining member (8a, 8b) joining the electronic component device (3) with the via hole electrode (5, 6).

4. The electronic component according to claim 3, wherein the protruding portion of said at least one via hole electrode does not extend along the face (2a) of said package member (2).

5. The electronic component according to claim 3 or 4, wherein the electronic component device (3) is a piezoelectric resonator.

6. The electronic component according to one of claims 3 to 5, wherein the via hole electrode (5, 6) is exposed to a second face (2b) of the package member (2); and the first (2a) and the second face (2b) of the package member are opposed to each other.

7. The electronic component according to one of claims 3 to 6, wherein the package member (31) comprises ceramic, a plurality of internal electrodes (39a, 39b) are provided in the package member (31) so as to form at least one capacitor, and the via hole electrode is electrically connected to the capacitor.

8. The electronic component according to one of claims 3 to 7, wherein the package member comprises a ceramic substrate, a plurality of cutaways are provided on a side of the ceramic substrate, and a plurality of external electrodes are provided in the plurality of cutaways respectively.

## Patentansprüche

1. Verfahren zum Ausbilden eines elektronischen Bauteils, das die folgenden Schritte umfasst:
Bilden eines Schichtstoffs aus einer Vielzahl von keramischen Grünfolien auf einem Trägerfilm, um einen Schichtstoff aus keramischen Grünfolien zu erhalten;
Ausbilden von Durchgangsbohrungen durch den Schichtstoff aus keramischen Grünfolien an Positionen, an denen sich Durchkontaktierungselektroden befinden sollen;
Einbringen von leitfähigem Material in die Durchgangsbohrungen, derart, dass es die Durchgangsbohrungen füllt und dass es auf der oberen Fläche des Schichtstoffs aus keramischen Grünfolien angeordnet ist, um Durchkontaktierungselektroden auszubilden; und
Sintern des Schichtstoffs aus keramischen Grünfolien, um ein Substrat auszubilden und derart, dass vorstehende Bereiche der Durchkontaktierungselektroden ausgebildet werden, die von der oberen Fläche des Substrats aus nach oben vorstehen.

2. Verfahren nach Anspruch 1, das ferner den Schritt des Kühlens des Schichtstoffs aus keramischen Grünfolien umfasst, wobei ein Koeffizient für den Wärmeschwund des Materials aus keramischen Grünfolien größer ist ein Koeffizient für den Wärmeschwund des leitfähigen Elektrodenmaterials.

3. Elektronisches Bauteil, das durch das Verfahren nach Anspruch 1 ausgebildet wird, umfassend:
ein Gehäuseelement (2);
eine Vielzahl von Durchgangsbohrungen, die in einem Gehäuseelement (2) vorgesehen sind;
zumindest eine Durchkontaktierungselektrode (5, 6), die in zumindest einer der Vielzahl von Durchgangsbohrungen vorgesehen ist und die sich durch die zumindest eine Durchgangsbohrung im Substrat (2) so erstreckt, dass sie um einen Überstandsbetrag von einer ersten Fläche (2a) des Gehäuseelements (2) vorsteht; und
eine elektronische Bauteilvorrichtung (3), die sich auf der ersten Fläche (2a) des Gehäuseelements mit einem Abstand (9) dazwischen befindet;
wobei der Abstand zwischen der elektronischen Bauteilvorrichtung (3) und der ersten Fläche des Gehäuseelements (2) durch den Überstandsbetrag der Durchkontaktierungselektrode (5, 6) bestimmt ist, die von der Fläche (2a) des Gehäuseelements (2) vorsteht;
ein Verbindungselement (8a, 8b), das die elektronische Bauteilvorrichtung (3) mit der Durchkontaktierungselektrode (5, 6) verbindet.

4. Elektronisches Bauteil nach Anspruch 3, wobei der vorstehende Bereich der zumindest einen Durchkontaktierungselektrode sich nicht entlang der Fläche (2a) des Gehäuseelements (2) erstreckt.

5. Elektronisches Bauteil nach Anspruch 3 oder 4, wobei es sich bei der elektronischen Bauteilvorrichtung (3) um einen piezoelektrischen Resonator handelt.

6. Elektronisches Bauteil nach einem der Ansprüche 3 bis 5, wobei die Durchkontaktierungselektrode (5, 6) bis zu einer zweiten Fläche (2b) des Gehäuseelements (2) reicht und dort frei liegt; und die erste (2a) und die zweite Fläche (2b) des Gehäuseelements einander gegenüber liegen.

7. Elektronisches Bauteil nach einem der Ansprüche 3 bis 6, wobei das Gehäuseelement (31) Keramik umfasst, eine Vielzahl von inneren Elektroden (39a, 39b) in dem Gehäuseelement (31) vorgesehen sind, um zumindest einen Kondensator zu bilden, und die Durchkontaktierungselektrode elektrisch mit dem Kondensator verbunden ist.

8. Elektronisches Bauteil nach einem der Ansprüche 3 bis 7, wobei das Gehäuseelement ein Keramiksubstrat umfasst, eine Vielzahl von Ausschnitten auf einer Seite des keramischen Substrats vorgesehen sind und entsprechend eine Vielzahl von äußeren Elektroden in der Vielzahl von Ausschnitten vorgesehen sind.

## Revendications

1. Procédé pour la formation d'un composant électronique, comprenant les étapes suivantes:
stratifier une pluralité de feuilles crues céramiques sur une feuille de support afin d'obtenir un stratifié en feuilles crues céramiques;
former des trous débouchants à travers le stratifié en feuilles crues céramiques à des positions où des électrodes de connexion transversale doivent être situées;
appliquer du matériau conducteur dans les trous débouchants de manière qu'il remplisse les trous débouchants et qu'il soit situé sur la surface supérieure du stratifié en feuilles crues céramiques afin de former des électrodes de connexion transversale; et
fritter le stratifié en feuilles crues céramiques pour former un substrat et afin que des zones saillantes des électrodes de connexion transversale soient formées qui font saillie de la face supérieure du substrat.

2. Procédé selon la revendication 1, comprenant en outre l'étape consistant à refroidir le stratifié en feuilles crues céramiques, un coefficient de contraction thermique du matériau en feuilles crues céramiques étant plus élevé qu'un coefficient de contraction thermique du matériau des électrodes conductrices.

3. Composant électronique formé par le procédé selon la revendication 1, comprenant:
un élément de boîtier (2);
une pluralité de trous débouchants prévus dans un élément de boîtier (2);
au moins une électrode de connexion transversale (5, 6) prévue dans au moins l'une de la pluralité de trous débouchants et s'étendant à travers au moins l'un des trous débouchants dans le substrat (2) afin de saillir d'une quantité de saillie à partir d'une première face (2a) dudit élément de boîtier (2); et
un dispositif de composant électronique (3) situé sur la première face dudit élément de boîtier avec un espace (9) entre ceux-ci;
l'espace entre le dispositif de composant électronique (3) et la première face dudit élément de boîtier (2) étant déterminé par la quantité de saillie de l'électrode de connexion transversale (5, 6) qui saillit de la face (2a) dudit élément de boîtier (2);
un élément de raccordement (8a, 8b), qui raccorde le dispositif de composant électronique (3) à l'électrode de connexion transversale (5, 6).

4. Composant électronique selon la revendication 3 **caractérisé en ce que** la zone en saillie de ladite au moins une électrode de connexion transversale ne s'étend pas le long de la face (2a) dudit élément de boîtier (2).

5. Composant électronique selon la revendication 3 ou 4 **caractérisé en ce que** le dispositif de composant électronique (3) est un résonateur piézoélectrique.

6. Composant électronique selon l'une quelconque des revendications 3 à 5 **caractérisé en ce que** l'électrode de connexion transversale va jusqu'à une deuxième face (2b) de l'élément de boîtier (2) et y est mise à découvert; et **en ce que** la première (2a) et la deuxième face (2b) de l'élément de boîtier sont situées l'une en face de l'autre.

7. Composant électronique selon l'une quelconque des revendications 3 à 6 **caractérisé en ce que** l'élément de boîtier (31) comprend de la céramique, une pluralité d'électrodes internes (39a, 39b) est prévue dans l'élément de boîtier (31) afin de former au moins un condensateur et l'électrode de connexion transversale est connectée électriquement au condensateur.

8. Composant électronique selon l'une quelconque des revendications 3 à 7 **caractérisé en ce que** l'élément de boîtier comprend un substrat céramique, une pluralité de découpures est prévue sur un coté du substrat céramique et une pluralité d'électrodes externes est prévue dans la pluralité de découpures respectivement.
